# EUROPÄISCHE PATENTANMELDUNG

(11) **EP 2 395 558 A1**
(43) Veröffentlichungstag der Anmeldung: **14.12.2011**
(21) Anmeldenummer: 10165622.1
(22) Anmeldetag: 11.06.2010
(51) Int. Cl.: H01L 31/048, B32B 17/10, C08L 29/14, C08K 3/22

(54) **Photovoltaikmodule mit reflektierenden Klebefolien geringer Verfärbungsneigung**

(71) Anmelder: Kuraray Europe GmbH, 65926 Frankfurt am Main (DE)
(72) Erfinder: Keller, Uwe, Dr., 53177 Bonn (DE)
(74) Vertreter: Kisters, Michael Marcus

(57) **Zusammenfassung**

Die Erfindung betrifft Photovoltaikmodule, umfassend ein Laminat aus
a) einer transparenten Frontabdeckung
b) einer oder mehreren photosensitiven Halbleiterschichten
c) mindestens einer Klebefolie und
d) einer rückwärtigen Abdeckung

wobei mindestens eine Klebefolie reflektierend ausgerüstet ist und Titandioxidpigment mit einem TiO₂,-Gehalt von 50 bis 95 Gew.% aufweist.

## Beschreibung

### Technisches Gebiet

Die Erfindung betrifft die Herstellung von Photovoltaikmodulen unter Verwendung von Sonnenlicht-Reflektierenden Klebefolien, die eine geringe Neigung zur Verfärbung zeigen.

Photovoltaikmodule bestehen häufig aus einer photosensitiven Schicht, die zwischen einer Glasplatte und einer hinteren Abdeckung angeordnet ist. Insbesondere wenn die hintere Abdeckung ebenfalls aus Glas besteht, werden diese Komponenten **über ein oder mehrere Zwischenschichtfolien aus** weichmacherhaltigem Polyvinylbutyral (PVB) miteinander verklebt.

Es ist zudem bekannt, dass ein Teil des Sonnenlichts die photosensitiven Schichten durchdringt, ohne diese anzuregen. Zur Verbesserung der Quantenausbeute können insbesondere die hinter den photosensitiven Schichten angeordneten Klebefolien reflektierende Materialien wie Titandioxid, Zirkondioxid oder Metallpigmente enthalten. **So ist aus** DE 4337694, WO 2009/071703, US 2007/0235077 oder US 5,059,254 die Verwendung von Titandioxid als reflektierendes Pigment in einer hinter der photosensitiven Schicht befindlichen PVB-Folie bekannt.

Titandioxid wird im großen Maßstab als Weißpigment z.B. für Dispersionsfarben oder zur Einfärbung von PVC-Profilen verwendet. Da Titandioxid in der Anastas-Modifikation, in geringerem Maße jedoch auch in der Rutil-Modifikation unter UV-Bestrahlung die Zersetzung einer Polymermatrix katalysiert, weisen die kommerziell erhältlichen Titandioxid-Pigmente in der Regel eine Beschichtung aus inerten anorganischen Materialien wie Siliziumoxiden, Aluminiumoxiden oder Zirkonoxiden auf. Diese Oxide haben einen niedrigeren Brechungsindex und damit eine wesentlich geringere Streukraft als Titandioxid selber. Bei höheren Anteilen an inerter Beschichtung fällt die Menge an Titandioxid im jeweiligen Pigment und damit die Streuwirkung des Pigmentes geringer aus. Um eine hohe Reflektionswirkung und damit einen besonders hohen additiven Beitrag zum Photostrom zu erhalten, **werden für** Photovoltaik-Anwendungen Titandioxidpigmente mit einem möglichst hohen Streuvermögen d.h. mit besonders hohem TiO₂-Gehalt verwendet.

Bei Beständigkeitstests wurde allerdings beobachtet, dass sich Titandioxid vom Rutil-Typ mit hohem TiO₂-Gehalt in einer damit gefüllten PVB-Folie unter UV-Bestrahlung blau verfärbt, womit die Reflektivität der Folie stark abnimmt. Der Effekt ist im Randbereich des Laminats, also dort, wo Luftsauerstoff nachdiffundieren kann, wesentlich weniger stark ausgeprägt und nur teilweise reversibel. Ohne an die Richtigkeit der Theorie gebunden zu sein, wird vermutet, dass der beobachtete Effekt im Zusammenhang mit intermediären Elektronenzuständen steht, welche sich in dieser Weise nur bei Abwesenheit von Sauerstoff stabilisieren können. Bei ungehindertem Zutritt von Luftsauerstoff über die nicht mit Glas bedeckte Oberfläche einer Klebefolie in einem Photovoltaikmodul treten diese Effekte nicht in dieser Weise auf.

Die Reflektivität einer mit Titandioxidpigment gefüllten Folie in einem Photovoltaikmodul nimmt somit innerhalb der langen Zeiträume, innerhalb derer ein PV-Modul der Sonneneinstrahlung ausgesetzt ist durch Verfärben stark ab. Damit nimmt die verbesserte Anfangsleistung des Moduls mit der Zeit ebenfalls zu einem Teil ab.

### Aufgabe

Aufgabe der vorliegenden Erfindung war es daher, Titandioxidhaltige Zwischenschichtfolien für Photovoltaikmodule zur Verfügung zu stellen, die eine geringere Verfärbung und damit einen geringeren Abbau der Reflektivität aufweisen.

Überraschenderweise wurde gefunden, dass durch Verwendung von Titandioxidpigment mit geringerem Anteil an TiO₂ in einer Zwischenschichtfolie zwar ein etwas geringeres Streuvermögen/geringere Reflektivität erreicht wird, die Reduktion der Reflektivität durch Verfärbung mit der Zeit aber wesentlich geringer ausfällt. Eine so ausgerüstete Folie besitze höhere Standzeiten und macht Photovoltaikmodule über ihre Lebensdauer effektiver.

### Darstellung der Erfindung

Gegenstand der vorliegenden Erfindung sind daher Photovoltaikmodule, umfassend ein Laminat aus
a) einer transparenten Frontabdeckung
b) einer **oder mehrerer** photosensitiven Halbleiterschichten
c) mindestens einer Klebefolie und
d) einer rückwärtigen Abdeckung
wobei mindestens eine Klebefolie reflektierend ausgerüstet ist und Titandioxidpigment mit einem TiO₂-Gehalt von 50 bis 95 Gew.% (bezogen auf das verwendete Pigment) aufweist. Das Titandioxidpigment enthält bevorzugt TiO₂ in der Rutil-Modifikation.

Durch die diffus reflektierend ausgerüstete Klebefolie wird ein Teil des Lichts, das die photosensitive Halbleiterschicht durchdringt, wieder auf diese zurückreflektiert, sodass sich die Effizienz des Moduls erhöht. Durch den Einsatz von ausgewählten Titandioxidpigmenten unterbleibt eine Verfärbung und die Effizienzsteigerung bleibt über die Lebensdauer des Moduls erhalten.

Erfindungsgemäß verwendete Folien weisen einen Erhalt der Reflektion bei 1100 nm vor und nach 1000h UV-Bestrahlung nach dem im folgenden beschriebenen Testverfahren von mindestens 85 %, bevorzugt von mindestens 90 % und insbesondere von mindestens 95 % auf.

**Erfindungsgemäß verwendete Folien enthalten** bevorzugt Titandioxidpigment welches mit einer oder mehreren Verbindungen der Gruppe Zinkoxid, Siliziumoxid, Aluminiumoxid und Zirkoniumoxid beschichtet ist. Bevorzugt wird als Beschichtungsmaterial eine Mischung von Silizium- und Aluminiumoxid eingesetzt.

Die erfindungsgemäß verwendeten Titandioxidpigment weisen bevorzugt eine mittlere Partikelgröße von 10-80 nm, besonders bevorzugt von 15-60 nm und insbesondere von 20-40 nm auf.

Der anorganische Anteil der für die erfindungsgemäßen Folien verwendeten Titandioxidpigmente enthält daher maximal 95 Gew.% TiO₂. Bevorzugt enthalten die erfindungsgemäße verwendeten Pigmente maximal 93 Gew.%, besonders bevorzugt maximal 92 Gew.% TiO₂, insbesondere maximal 91 Gew.% TiO₂,Der TiO₂,-Gehalt der Titandioxidpigmente sollten jedoch mehr als 50 % TiO₂, bevorzugt mehr als 70 % TiO₂, , besonders bevorzugt mehr als 80 % TiO₂, und insbesondere mehr als 85 % betragen, da sonst die Reflektivität der Folie zu gering wird.

Weiterhin können die Titandioxidpigmente zur Erleichterung der gleichmäßigen Einarbeitung in die Folienmatrix optional mit organischen Verbindungen oberflächenbehandelt sein. Beispiele hierfür sind Organophosphate, Organosulfate, multifunktionelle Alkohole wie Trimethylolpropan (TMP) oder Siliconverbindungen wie Polydimethylsiloxan (PDMS). Bevorzugt besteht die Oberflächenbehandlung aus einer Siliconverbindung wie PDMS. Weniger geeignet sind polyfunktionelle Alkohole (z.B. TMP), da diese die Blauverfärbung verstärken können.

Der neben dem TiO₂, zu 100 % fehlende Rest der Titandioxidpigmente besteht aus den genannten, anorganischen und/oder organischen Verbindungen.

Die erfindungsgemäß eingesetzte reflektierende Klebefolie ist bevorzugt eine einlagige Folie. Es kann aber vorteilhaft sein, dass die reflektierende Klebefolie aus mindestens einer reflektierenden d.h. pigmenthaltigen Schicht (Teilfolie) und mindestens einer nicht-reflektierenden d.h. pigmentfreien Schicht (Teilfolie)besteht. So können z.B. ein oder zwei außen liegende Teilschichten die Klebewirkung bewirken, während die dazwischen liegende, die reflektierenden Pigmente enthaltende Teilschicht für die Reflexion der Strahlung sorgt.

Folien mit mehreren Teilschichten können durch Zusammenlegen von vorgefertigten Teilschichten oder durch Coextrusion der Teilschichten in einem Arbeitsgang hergestellt werden.

Der Anteil der Titandioxidpigmente in der reflektierenden Klebefolie beträgt bevorzugt mindestens 5 Gew.%, besonders bevorzugt mindestens 8 Gew.%, oder mindestens 10 Gew.% und insbesondere mindestens 12 Gew.-%. Als Obergrenze sollte jeweils 30 Gew.% eingehalten werden. Ist die Klebefolie aus pigmentfreien und pigmenthaltigen Teilschichten aufgebaut, so bezieht sich dieser Wert auf die Gesamtfolie, sodass in der pigmenthaltigen Teilschicht entsprechend der Dickenverteilung höhere TiO₂, Konzentrationen eingesetzt werden können.

Im Fall, das die reflektierende Zwischenschicht aus mindestens einer pigmentfreien und mindestens einer pigmenthaltigen

Teilschicht besteht, können diese Teilschichten jeweils eine unterschiedliche oder gleiche Zusammensetzung bzw. polymere Materialien enthalten.

Als Material für die reflektierenden Klebe- und Teilschichten können die für Verbundverglasungen bekannten Materialien eingesetzt werden, wie z.B. PVC, Geniomer (Polydimethylsiloxan/Harnstoff-Copolymer), Silikone, Polyurethan, Ethylen/Vinylacetat (EVA), Epoxydgießharze, Ionomere, Polyolefine oder insbesondere weichmacherhaltige Polyvinylacetale oder weichmacherhaltige Polyvinylbutyrale.

Die weichmacherhaltiges Polyvinylacetal enthaltenden Folien enthalten bevorzugt unvernetztes Polyvinylbutyral (PVB), das durch Acetalisierung von Polyvinylalkohol mit Butyraldehyd gewonnen wird.

Der Einsatz von vernetzten Polyvinylacetalen, insbesondere vernetztem Polyvinylbutyral (PVB) ist ebenso möglich. Geeignete vernetzte Polyvinylacetale sind z.B. in EP 1527107 B1 und WO 2004/063231 1 A1 1 (thermische Selbstvernetzung von Carboxylgruppenhaltigen Polyvinylacetalen), EP 1606325 A1 (mit Polyaldehyden vernetzte Polyvinylacetale) und WO 03/020776 A1 (mit Glyoxylsäure vernetzte Polyvinylacetale) beschrieben. Auf die Offenbarung dieser Patentanmeldungen wird vollumfänglich Bezug genommen.

Es ist auch möglich, die Acetalisierung mit anderen oder weiteren Aldehyden mit 5-10 Kohlenstoffatomen (z.B. wie Valeraldehyd) durchzuführen.

Als Polyvinylalkohol können im Rahmen der vorliegenden Erfindung auch Terpolymere aus hydrolysierten Vinylacetat/Ethylen-Copolymeren eingesetzt werden. Diese Verbindungen sind in der Regel zu mehr als 98% hydrolysiert und enthalten 1 bis 10 Gew. auf Ethylen basierende Einheiten (z.B. Typ "Exceval" der Kuraray Europe GmbH).

Polyvinylacetale enthalten neben den Acetaleinheiten noch aus Vinylacetat und Vinylalkohol resultierende Einheiten. Die erfindungsgemäß verwendeten weichmacherhaltige Polyvinylacetale weisen bevorzugt einen Polyvinylalkoholanteil von weniger als 20 Gew.%, weniger als 18 Gew.% oder insbesondere weniger als 16 Gew.% auf. Ein Polyvinylalkoholanteil von 12 Gew.% sollte nicht unterschritten werden.

Der Polyvinylacetatanteil des Polyvinylacetals liegt bevorzugt unter 5 Gew.%, bevorzugt unter 3 Gew.% und insbesondere unter 2 Gew.% Aus dem Polyvinylalkoholanteil und dem Restacetatgehalt kann der Acetalisierungsgrad rechnerisch ermittelt werden.

Die erfindungsgemäß eingesetzten reflektierenden Folien weisen bei einer Umgebungsfeuchte von 85% rF bei 23°C bevorzugt einen spezifischen Widerstand von mindestens 1E+11 ohm*cm, bevorzugt mindestens 5E+11 ohm*cm, bevorzugt 1E+12 ohm*cm, bevorzugt 5E+12 ohm*cm, bevorzugt 1E+13, bevorzugt 5E+13 ohm*cm, bevorzugt 1E+14 ohm*cm auf.

Bevorzugt weisen die erfindungsgemäß eingesetzten Folien, insbesondere solche auf Basis von weichmacherhaltigem Polyvinylacetal, einen Weichmachergehalt von maximal 40 Gew.%, 35 Gew.%, 32 Gew.%, 30 Gew.%, 28 Gew.%, 26 Gew.%, 24 Gew.%, 22 Gew.%, 20 Gew. %, 18 Gew. %, 16 Gew. % auf, wobei ein Weichmachergehalt von 15 Gew.% aus Gründen der Verarbeitbarkeit der Folie nicht unterschritten werden sollte (jeweils bezogen auf die gesamte Folienformulierung). Erfindungsgemäße Folien bzw. Photovoltaikmodule können einen oder mehrere Weichmacher enthalten.

Grundsätzlich geeignete Weichmacher für die erfindungsgemäß eingesetzten Folien auf Basis von Polyvinylacetalen sind eine oder mehrere Verbindungen ausgewählt aus den folgenden Gruppen:
- Ester von mehrwertigen aliphatischen oder aromatischen **Säuren, z.B. Dialky** ladipate wie Dihexyladipat, Dioctyladipat, Hexylcyclohexyladipat, Mischungen aus Heptyl-und Nonyladipaten, Diisononyladipat, Heptylnonyladipat sowie Ester der Adipinsäure mit cycloaliphatischen oder Etherbindungen enthaltenden Esteralkoholen, Dialkylsebazate wie Dibutylsebazat sowie Ester der Sebazinsäure mit cycloaliphatischen oder Etherbindungen enthaltenden **Esteralkoholen, Estern der Phthalsäure wie** Butylbenzylphthalat oder Bis-2-butoxyethylphthalat
- Ester oder Ether von mehrwertigen aliphatischen oder aromatischen Alkoholen oder Oligoetherglykolen mit einem oder mehreren unverzweigen oder verzweigten aliphatischen oder aromatischen Substituenten, wie z.B. Estern von Di-, Tri- oder Tetraglykolen mit linearen oder verzweigten aliphatischen oder cycloaliphatischen Carbonsäuren; Als Beispiele für letztere Gruppe können dienen Diethylenglykolbis- (2-ethylhexanoat), Triethylenglykol-bis- (2-ethylhexanoat), Triethylenglykol-bis-(2-ethylbutanoat), Tetraethylenglykol-bis-n-heptanoat, Triethylenglykol-bis-n-heptanoat, Triethylenglykol-bis-n-hexanoat, Tetraethylenglykoldimethylether und/oder Dipropylenglykolbenzoat
- Phosphate mit aliphatischen oder aromatischen Esteralkoholen wie z.B. Tris(2-ethylhexyl)phosphat (TOF), Triethylphosphat, Diphenyl-2-ethylhexylphosphat, und/oder Trikresylphosphat
- Ester der Zitronensäure, Bernsteinsäure und/oder Fumarsäure

Gut geeignet als Weichmacher für die erfindungsgemäß eingesetzten Folien auf Basis von Polyvinylacetalen sind eine oder mehrere Verbindungen ausgewählt aus der folgenden Gruppe Di-2-ethylhexylsebacat (DOS), Di-2-ethylhexyladipat (DOA), Dihexyladipat (DHA), Dibutylsebacat (DBS), Triethylenglykol-bis-n-heptanoat (3G7), Tetraethylenglykol-bis-n-heptanoat (4G7), Triethylenglykol-bis-2-ethylhexanoat (3GO bzw. 3G8) Tetraethylenglykol-bis-n-2-ethylhexanoat (4GO bzw. 4G8) Di-2-butoxyethyladipat (DBEA), Di-2-butoxyethoxyethyladipat (DBEEA) Di-2-butoxyethylsebacat (DBES), Di-2-ethylhexylphthalat (DOP), Di-isononylphthalat (DINP) Triethylenglykol-bis-isononanoat, Triethylenglykol-bis-2-propylhexanoat, Tris(2-ethylhexyl)phosphat (TOF), 1,2-**Cyclohexandicarbonsäurediisononylester** (DINCH), Diisononyladipat (DINA) und Dipropylenglykolbenzoat.

Ganz besonders geeignet als Weichmacher für die erfindungsgemäß eingesetzten Folien auf Basis von Polyvinylacetalen sind Weichmacher, deren Polarität, ausgedrückt durch die Formel 100 x O/(C+H) kleiner/gleich 9.4 ist, wobei O, C und H für die Anzahl der Sauerstoff-, Kohlenstoff- und Wasserstoffatome im jeweiligen Molekül steht. Die nachfolgende Tabelle zeigt erfindungsgemäß einsetzbare Weichmacher und deren Polaritätswerte nach der Formel 100 x O/(C+H).

| Name | Abkürzung | 100 x O/(C+H) |
|---|---|---|
| Di-2-ethylhexylsebacat | (DOS) | 5,3 |
| Diisononyladipat | (DINA) | 5,3 |
| 1,2-Cyclohexandicarbonsäurediisononylester | (DINCH) | 5,4 |
| Di-2-ethylhexyladipat | (DOA) | 6,3 |
| Di-2-ethylhexylphthalat | (DOP) | 6,5 |
| Dihexyladipat | (DHA) | 7,7 |
| Dibutylsebacat | (DBS) | 7,7 |
| Triethylenglykol-bis-2-propylhexanoat | | 8,6 |
| Triethylenglykol-bis-i-nonanoat | | 8,6 |
| Di-2-butoxyethylsebacat | (DBES) | 9,4 |
| Triethylenglykol-bis-2-ethylhexanoat | (3G8) | 9,4 |

Das Haftungsvermögen von Polyvinylacetalfolien an Glas wird üblicherweise durch die Zugabe von Haftungsregulatoren wie z. B. die in WO 0 3 / 0 3 3 5 8 3 A1 offenbarten Alkali- und/oder Erdalkalisalze von organischen Säuren eingestellt. Als besonders geeignet haben sich Kaliumacetat und/oder Magnesiumacetat herausgestellt. Zudem enthalten Polyvinylacetale aus dem Herstellungsprozess häufig Alkali-und/oder Erdalkalisalze von anorganischen Säuren, wie z.B. Natriumchlorid.

Da Alkalimetallsalze ebenfalls einen Einfluss auf den spezifischen Widerstand haben, ist der Einsatz von weichmacherhaltigen, auf Polyvinylacetal basierenden Folien mit weniger als 100 ppm, besonders bevorzugt mit weniger als 50 ppm und insbesondere mit weniger als 30 ppm Alkalimetallionen zweckmäßig. Dies kann durch entsprechende Waschverfahren des Polyvinylacetals und durch Verwendung von mehrwertigen Metallsalzen ausgewählt aus der Gruppe Erdalkalimetall-, Zink-und Aluminiumsalze als basischem Stabilisator erreicht werden. Bevorzugt werden Magnesiumsalze, insbesondere Magnesiumacetat, -propionat, -butyrat, -hexanoat, -octoat und Magnesiumstearat. Die erfindungsgemäß verwendete reflektierende Folie weist bevorzugt einen Alkalititer von größer 0, besonders bevorzugt größer 5, insbesondere größer 10 oder größer 15 auf. Ein Alkalititer von 100 sollte nicht überschritten werden, da anderenfalls Gelbfärbung der Folie resultieren kann.

Weiterhin kann die möglicherweise vom Wassergehalt der Folie abhängende Ionenbeweglichkeit und damit der spezifische Widerstand durch den Zusatz von pyrogener Kieselsäure beeinflusst werden. Bevorzugt enthalten die weichmacherhaltigen, auf Polyvinylacetal basierenden Folien 0.001 bis 15 Gew.%, bevorzugt 2 bis 5 Gew.% pyrogenes SiO₂,

Die prinzipielle Herstellung und Zusammensetzung von Folien auf Basis von Polyvinylacetalen ist z. B. in EP 185 863 B1, EP 1 118 258 B1 WO 02/102591 A1, EP 1 118 258 B1 oder EP 387 148 B1 beschrieben.

Die Laminierung der Photovoltaikmodule erfolgt unter Verschmelzung der Folien, so dass ein blasen- und schlierenfreier Einschluss der photosensitiven Halbleiterschicht mit den Folien erhalten wird.

Die Gesamtdicke der Klebefolien liegt üblicherweise bei 0.30, 0.38, 0,45, 0.51, 0.76, 1.14 mm.

Erfindungsgemäß eingesetzte Folien füllen während des Laminierprozesses die an den photosensitiven Halbleiterschichten bzw. deren elektrischen Verbindungen vorhandenen Hohlräume aus.

Die transparente Frontabdeckung besteht in der Regel aus Glas oder PMMA. Die rückwärtige Abdeckung des erfindungsgemäßen Photovoltaikmoduls kann aus Glas, Kunststoff oder Metall oder deren Verbünden bestehen, wobei mindestens einer der Träger transparent sein kann. Es ist ebenfalls möglich, einen oder beide Abdeckungen als Verbundverglasung (d. h. als Laminat aus mindestens zwei Glasscheiben und mindestens einer PVB-Folie) oder als Isolierverglasung mit einem Gaszwischenraum auszuführen. Selbstverständlich ist auch die Kombination dieser Maßnahmen möglich.

Die in den Modulen eingesetzten photosensitiven Halbleiterschichten müssen keine besonderen Eigenschaften besitzen. Es können mono-, polykristalline oder amorphe Systeme eingesetzt werden.

Werden erfindungsgemäße Dünnschicht-Solarmodule hergestellt, so sind die photosensitiven Halbleiterschichten in der Regel direkt auf die transparente Frontabdeckung aufgebracht und mit der rückwärtigen Abdeckung durch mindestens eine erfindungsgemäße Klebefolie verklebt.

Im Fall der Herstellung von kristallinen oder geträgerten Solarmodulen müssen die Solarmodule von Klebefolien eingekapselt werden, d.h. dass die photosensitiven Halbleiterschichten b) mit mindestens einer, nicht reflektierenden Klebefolie mit der transparenten Frontabdeckung a) und die rückwärtigen Abdeckung d) durch mindestens eine erfindungsgemäße Klebefolie verklebt sind. Diese Folien weisen bevorzugt bis auf die reflektierenden Pigmente eine gleiche Zusammensetzung wie reflektierende Klebefolien auf.

Zur Laminierung des so erhaltenen Schichtkörpers können die dem Fachmann geläufigen Verfahren mit und ohne vorhergehende Herstellung eines Vorverbundes eingesetzt werden.

So genannte Autoklavenprozesse werden bei einem erhöhten Druck von ca. 10 bis 15 bar und Temperaturen von 130 bis 145 °C über ca. 2 Stunden durchgeführt. Vakuumsack- oder Vakuumringverfahren z.B. gemäß EP 1 235 683 B1 arbeiten bei ca. 200 mbar und 130 bis 145 °C

Vorzugsweise werden zur Herstellung der erfindungsgemäßen Photovoltaikmodule Vakuumlaminatoren eingesetzt. Diese bestehen aus einer beheizbaren und evakuierbaren Kammer, in denen Verbundverglasungen innerhalb von 10 - 60 Minuten laminiert werden können. Verminderte Drücke von 0,01 bis 300 mbar und Temperaturen von 100 bis 200 °C, insbesondere 130 - 160 °C haben sich in der Praxis bewährt.

Alternativ kann ein so oben beschrieben zusammengelegter Schichtkörper zwischen mindestens einem Walzenpaar bei einer Temperatur von 60 bis 150 °C zu einem erfindungsgemäßen Modul verpresst werden. Anlagen dieser Art sind zur Herstellung von Verbundverglasungen bekannt und verfügen normalerweise über mindestens einen Heiztunnel vor bzw. nach dem ersten Presswerk bei Anlagen mit zwei Presswerken.

Erfindungsgemäße Photovoltaikmodule können als Fassadenbauteil, Dachflächen, Wintergartenabdeckung, Schallschutzwand, Balkon-oder Brüstungselement oder als Bestandteil von Fensterflächen verwendet werden.

### Messmethoden:

Die Messung des spezifischen Durchgangswiderstandes der Folie erfolgt gemäß DIN IEC 60093 bei definierter Temperatur und Umgebungsfeuchte (23 °C und 85 % rLF) nachdem die Folie wenigstens 24h bei diesen Bedingungen konditioniert wurde. Zur Durchführung der Messung wurde eine Plattenelektrode Typ 302 132 von der Firma Fetronic GmbH sowie ein Widerstandsmessgerät ISO-Digi 5kV von der Firma Amprobe verwendet. Die Prüfspannung betrug 2,5 kV, die Wartezeit nach Anlegen der Prüfspannung bis zur Messwerterfassung 60 sek. Damit ein ausreichender Kontakt zwischen den flachen Platten der Messelektrode und der Folie gewährleistet ist, sollte deren Oberflächenrauhikgkeit R_{z} bei Messung nach DIN EN ISO 4287 nicht größer als 10 µm sein, d.h. gegebenenfalls muss die Originaloberfläche der PVB-Folie vor der Widerstandsmessung durch thermisches Umprägen geglättet werden.

Der Polyvinylalkohol- und Polyvinylalkoholacetatgehalt der Polyvinylacetale wurde gemäß ASTM D 1396-92 bestimmt. Der Wasser- bzw. Feuchtegehalt der Folien wird mit der Karl-Fischer-Methode bestimmt.

### Alkali-Titer

3 bis 4 gr. des weichmacherhaltigen Polyvinylacetal-Films wird in 100 ml einer Mischung von Ethanol/THF (80:20) in einem Magnetrührer über Nacht gelöst. Hierzu werden 10 ml einer verdünnten Salzsäure (c=0,01 mol/Liter) gegeben und anschließend potentiometrisch mit einer Lösung von Tetrabutylammoniumhydroxid (TBAH) in 2-Propanol (c=0,01 mol/Liter) mit einem Titroprozessor gegen eine Leerprobe potentiometrisch titriert. Der Alkali-Titer berechnet sich wie folgt:
Alkali-Titer = ml HCI pro 100 gr einer Probe = (Verbrauch TBAH Leerprobe - TBAH Probe x 100 durch Gewicht der Probe in gr.)

### Beispiele:

Es wurden weichmacherhaltige Polyvinylbutyralfolien gemäß der in der Tabelle angegebenen Zusammensetzung mit Titandioxidpigment auf ihre Eignung als reflektierende Klebefolie in Photovoltaikmodulen untersucht. Die Folien bestanden aus weichgemachtem Polyvinylbutyral (PVB) mit dem angegebenen Polyvinylalkoholgehalt (PVOH) in Gew.% und einem Polyvinylacetatgehalt von ca. 1 Gew.%.

Die Strahlungsbeständigkeit der verschiedenen Ti02-Typen wurde an Glas/Glas-Laminaten der Zusammensetzung verglichen:
- 2 mm Optiwhite (eisenarmes Glas der Firma Pilkington
- 0.76 mm PVB-Folie enthaltend 12.5 Gewichtsprozent des jeweiligen Titandioxidpigmentes
- 2 mm Optiwhite

Die Folien wurde vor dem Einlaminieren in einem Klima von 23 °C / 23 % rF während 24h konditioniert, die Gläser auf einer Glaswaschmaschine mit 50 °C warmen VE-Wasser gereinigt. Die Laminate wurden anschließend in dem für Verbundglas typischen Walze / Autoklav-Verfahren bei einer Maximaltemperatur von 140 °C hergestellt.

Die Laminatmuster wurden in einem "Q-SUN Xenon Test Chamber Model Xe-3-HBS" während 1000 h bestrahlt. Die Bestrahlungsstärke bei 340 nm betrug 0,55 W/m2 bei einer Schwarzkacheltemperatur von 80 °C, Lufttemperatur von 45 °C und 20% relativer Feuchte. Die Messung der Reflektion erfolgte gemäß EN 410 auf einen UV/VIS/NIR-Spektrometer Lambda 950 des Herstellers Perkin Elmer vor der Bestrahlung und 24 Stunden nach Entnahme der Proben aus der Bestrahlungskammer. Aus den Spektren wurden die jeweiligen Reflektionswerte bei der Wellenlänge 1100 nm entnommen.

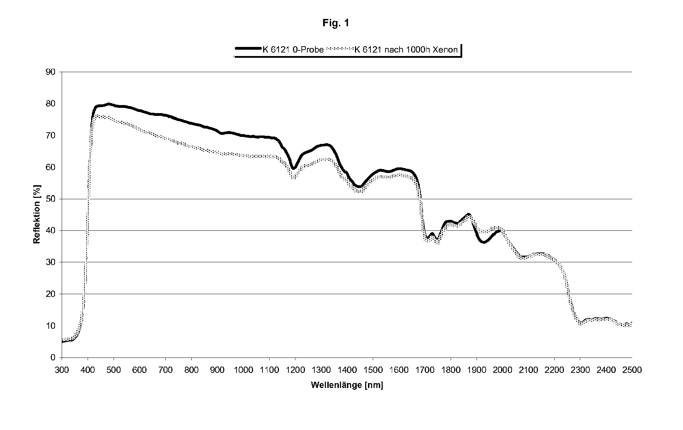

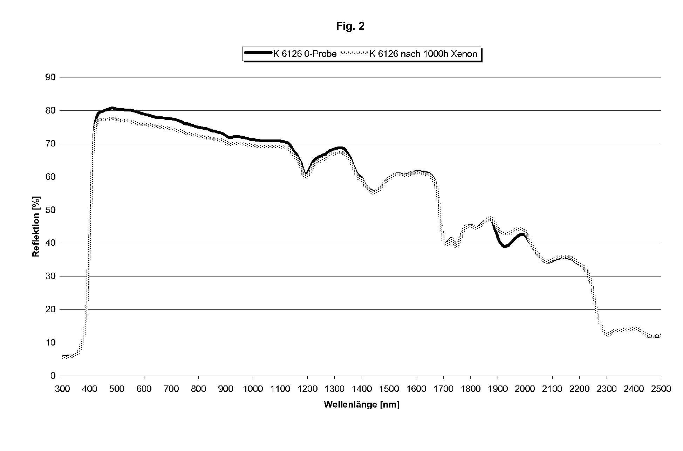

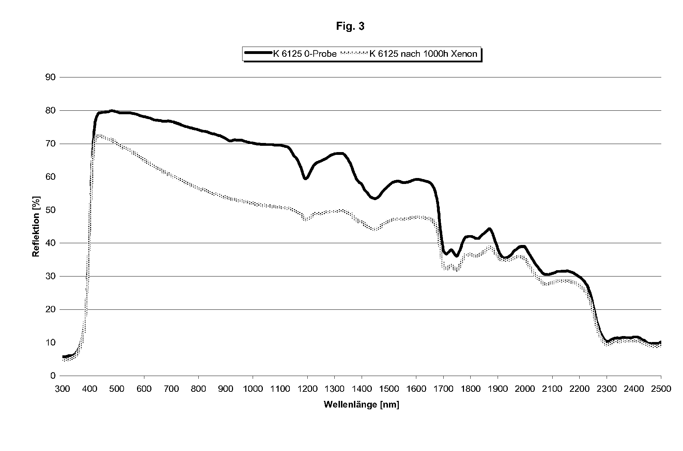

Die Fig. 1, 2 und 3 zeigen die Reflektivität in % von Laminatmustern nach den Beispielen 1, 4 und Vergleichsbeispiel 2 in Abhängigkeit von der Wellenlänge des gestreuten Lichts. Die oberen Kurven zeigen Reflektivität vor und die unteren Kurven die Reflektivität nach Bestrahlung.

Die Werte der folgende Tabelle und die Figuren zeigen, dass erfindungsgemäß aufgebaute Zwischenschichtfolien trotz eines geringeren relativen Streuvermögens (nach Herstellerangaben) des Pigmenttyps nach einer UV-Bestrahlung eine geringere Verfärbung bzw. ein erhöhtes Reflektionsvermögen aufweisen. Folien dieser Art sind daher besonders zur Herstellung von Photovoltaikmodulen geeignet.

Alle Angaben der Tabelle sind in Gew.% bezogen auf die Folienmischung d.h. bezogen auf Summe (PVB, Weichmacher und Ti02). Der PVOH-Gehalt im PVB ist bezogen auf das PVB, der Ti02-Gehalt auf das verwendete Titandioxidpigment. Mg(Acetat)2 x 4 H2O wird als Antihaftmittel zugesetzt

Die verwendeten Titandioxide wurden von der Fa. Kronos unter den angegebenen Produktbezeichnungen bezogen.

**Tabelle 1**

| | | Bsp1 | Bsp 2 | VBsp 1 | Bsp.3 | VBsp 2 | Bsp 4 | Bsp 5 |
|---|---|---|---|---|---|---|---|---|
| | Versuchsnummer | K 6121 | K 6122 | K 6123 | K 6124 | K 6125 | K 6126 | K 6127 |
| PVB | Gew.-% | 64,8 | 64,8 | 64,8 | 64,8 | 64,8 | 64,8 | 64,8 |
| PVOH-Gehalt im PVB | Gew-% | 20,0 | 20,0 | 20,0 | 20,0 | 20,0 | 20,0 | 14,6 |
| 3G8 | Gew.-% | 22,7 | 22,7 | 22,7 | 22,7 | 22,7 | 22,7 | - |
| DINCH | Gew.-% | - | - | - | - | - | - | 22,7 |
| Mg(Ac)2 x 4 H₂O | Gew.-% | 0,015 | 0,015 | 0,015 | 0,015 | 0,015 | 0,015 | 0,015 |
| Menge Titandioxidpigment | Gew.-% | 12,5 | 12,5 | 12,5 | 12,5 | 12,5 | 12,5 | 12,5 |
| Produktname KRONOS | | 2220 | 2222 | 2225 | 2226 | 2450 | 2081 | 2081 |
| Relatives Streuvermögen gemäß Herstellerangabe | % | 99 | 103 | 101 | 100 | 106 | 88 | 88 |
| organische Oberflächenbehandlung gemäß Herstellerdokumentation | | PDMS | PDMS | TMP | PDMS | PDMS/TMP | - | - |
| TiO₂,Gehalt nach ISO 591 gemäß Herstellerdokumentation | % | ≥ 92,5 % | ≥ 92,5 % | >_ 94,5 % | >_ 94,5 % | ≥ 96 % | ≥ 91 % | ≥ 9 % |
| % Reflektion bei 1100 nm vor UV-Bestrahlung | % | 69 | 69 | 70 | 70 | 70 | 71 | 70 |
| % Reflektion bei 1100 nm nach 1000h UV-Bestrahlung | % | 63 | 62 | 55 | 61 | 51 | 69 | 70 |
| % Erhalt der Reflektion bei 1100 nm nach 1000h Bestrahlung | | 91% | 90% | 79% | 87% | 73% | 97% | 100% |
| Alkalititer der Folie | | 15 | 14 | 12 | 13 | 16 | 15 | 14 |
| Elektrischer Durchgangswiderstand DIN IEC 60093 | Ohm x cm | 7,6 E+11 | 4,8 E+11 | 3,4 E+11 | 3,8 E+11 | 6,4 E+11 | 1,0 E+12 | > 1,0 E+14 |

## Patentansprüche

1. Photovoltaikmodul, umfassend ein Laminat aus
a) einer transparenten Frontabdeckung
b) einer oder mehreren photosensitiven Halbleiterschichten
c) mindestens einer Klebefolie und
d) einer rückwärtigen Abdeckung
**dadurch gekennzeichnet, dass** mindestens eine Klebefolie reflektierend ausgerüstet ist und Titandioxidpigment mit einem TiO₂,-Gehalt von 50 bis 95 Gew.% aufweist.

2. Photovoltaikmodul nach Anspruch 1 **dadurch gekennzeichnet, dass** das Titandioxidpigment mit einer oder mehrerer Verbindungen der Gruppe Zinkoxid, Siliziumoxid, Aluminiumoxid und/oder Zirkoniumoxid beschichtet ist.

3. Photovoltaikmodul nach Anspruch 2, **dadurch gekennzeichnet, dass** das Titandioxidpigment mit einer Mischung von Siliziumoxid und Aluminiumoxid beschichtet ist

4. Photovoltaikmodul nach einem der Ansprüche 1 bis 3 **dadurch gekennzeichnet, dass** die Titandioxidpigmente mit einer Siliconverbindung, einem multifunktionellen Alkohol einer Organosulfatverbindung und/**oder einer** Organophosphatverbindung oberflächenbehandelt sind.

5. Photovoltaikmodul nach einem der Ansprüche 1 bis 4 **dadurch gekennzeichnet, dass** die reflektierende Klebefolie aus mindestens einer pigmentfreien und mindestens einer pigmenthaltigen Teilschicht besteht.

6. Photovoltaikmodul nach einem der Ansprüche 1 bis 5 **dadurch gekennzeichnet, dass** die reflektierende Klebefolie aus mindestens einer pigmentfreien und mindestens einer pigmenthaltigen Teilschicht besteht und diese Teilschichten das gleiche polymere Material enthalten.

7. Photovoltaikmodul nach einem der Ansprüche 1 bis 6, **dadurch gekennzeichnet, dass** die reflektierende Klebefolie mindestes ein weichmacherhaltiges Polyvinylacetal enthält.

8. Photovoltaikmodul nach einem der Ansprüche 1 bis 7, **dadurch gekennzeichnet, dass** die reflektierende Klebefolie einen Alkalititer von größer 0 aufweist.

9. Photovoltaikmodul nach einem der Ansprüche 1 bis 8, **dadurch gekennzeichnet, dass** die reflektierende Klebefolie ein weichmacherhaltiges Polyvinylacetal mit einen Polyvinylalkoholanteil von weniger als 20 Gew.% enthält

10. Photovoltaikmodul nach einem der Ansprüche 1 bis 9 **dadurch gekennzeichnet, dass** die reflektierende Klebefolie mindestens einen Weichmacher ausgewählt aus der Gruppe Di-2-ethylhexylsebacat (DOS), 1,2-Cyclohexandicarbonsäurediisononylester (DINCH), Diisononyladipat (DINA), Di-2-ethylhexyladipat (DOA), Di-2-ethylhexylphthalat (DOP), Dihexyladipat (DHA), Dibutylsebacat (DBS), Triethylenglykol-bis-2-propylhexanoat, Triethylenglykol-bis-i-nonanoat, Di-2-butoxyethylsebacat (DBES) und Triethylenglykol-bis-2-ethylhexanoat (3G8) aufweist.

11. Photovoltaikmodul nach einem der Ansprüche 1 bis 10 **dadurch gekennzeichnet, dass** die reflektierende Klebefolie bei einer Umgebungsfeuchte von 85% rF bei 23°C einen spezifischen Widerstand von mindestens 1E+11 ohm*cm besitzen.
